# EUROPEAN PATENT APPLICATION

(11) **EP 3 855 511 A1**
(43) Date of publication of application: **28.07.2021**
(21) Application number: 19862734.1
(22) Date of filing: 30.07.2019
(51) Int. Cl.: H01L 31/18, H01L 31/0216, H01L 31/068

(54) **CRYSTALLINE SILICON SOLAR CELL AND PREPARATION METHOD THEREFOR**

(30) Priority: 17.09.2018 CN 201811081406
(71) Applicant: Zhejiang Aiko Solar Energy Technology Co., Ltd., Yiwu, Zhejiang 322009 (CN); Guangdong Aiko Solar Energy Technology Co., Ltd., Foshan, Guangdong 528000 (CN)
(72) Inventor: WU, Huimin, Suxi Town Yiwu, Zhejiang 322009 (CN); ZHANG, Xiaoming, Suxi Town Yiwu, Zhejiang 322009 (CN); FANG, Jiebin, Suxi Town Yiwu, Zhejiang 322009 (CN); LIN, Kang-Cheng, Suxi Town Yiwu, Zhejiang 322009 (CN); CHEN, Gang, Suxi Town Yiwu, Zhejiang 322009 (CN)
(74) Representative: Ipside
(86) International application number: PCT/CN2019/098437
(87) International publication number: WO 2020/057263

(57) **Abstract**

A method for preparing a crystalline silicon solar cell, comprising the steps of: front-face texturing; depositing a tunneling layer, a doped polysilicon layer, and an anti-reflection film layer on the front face; front-face film removal; front-face texturing for the second time; diffusion; etching; depositing a passivation film on a back face; depositing an anti-reflection film on the front face for the second time; back-face perforation; electrode etching; and sintering. By means of the preparation method of the present invention, a selective passivation contact crystalline silicon solar cell is prepared. The present method effectively ensures that the passivation tunneling layer is selectively doped in the positive electrode region, and effectively exerts a passivation effect. In addition, a non-electrode region is not blocked, thus reducing a degree to which a conventional doped silicon layer absorbs solar energy, and improving the efficiency of a solar cell.

## Description

### Technical Field

The present invention relates to the field of crystalline silicon solar cells, and in particular, to a selective passivation contact crystalline silicon solar cell and a preparation method thereof.

### Background of the Invention

Due to the continuous decrease in the thickness of silicon wafers in crystalline silicon cells, and for cells with a specific thickness, when the diffusion length of a minority of carriers is greater than the thickness of the silicon wafer, the surface recombination velocity has particularly significant impact on the efficiency of the solar cell. Therefore, most of existing technologies are to passivate the surface of crystalline silicon. Specifically, the backside passivation technology is to deposit a silicon nitride film on the back of a cell to reduce the back recombination velocity and effectively alleviate the problem of contact recombination between crystalline silicon and metal on the back face and improve the efficiency of the cell. Therefore, the backside passivation technology can greatly improve the efficiency of crystalline silicon solar cells.

The success of the backside passivation technology provides a feasible way to improve the efficiency of solar cells, that is, to passivate the front face of solar cells. At present, mainstream passivation technologies are to deposit a silicon nitride passivation film on the front face of the cell to alleviate the recombination problem. An advanced technology is to use the tunneling oxide layer passivation contact technology (TOPCon). In the passivation tunneling technology, an n-type silicon wafer is used as a substrate, and a tunneling layer is first deposited on the front and back faces of the silicon wafer, and then is covered by a thin-film silicon layer, thus forming tunneling oxide layer passivation contact.

The tunneling oxide layer passivation technology can form a tunneling film between the electrode and the substrate, isolate the metal electrode from coming into contact with the substrate, reduce contact recombination loss, and enable electrons to tunnel through the film without affecting current transfer. In addition, passivation can bend the surface energy band and reduce surface recombination loss of P-type silicon wafers, thus effectively alleviating front passivation and metal contact problems. However, the thin-film silicon layer arranged on the tunneling oxide layer generally has a strong light absorption capability, which reduces the output efficiency of the cell, and thus affects the efficiency of solar cells. Therefore, researchers are focusing on how to develop a passivation contact crystalline silicon solar cell that can not only utilize the advantages of the passivation contact technology, but also avoid the problem of current decrease caused by the absorption capability of the crystalline silicon film, so as to fully improve the conversion efficiency of the cell.

### Summary of the Invention

In view of the previous description, to resolve a technical problem, the present invention provides a selective passivation contact crystalline silicon solar cell and a preparation method thereof, so as to effectively utilize advantages of passivation and reduce surface recombination without affecting light absorption on a surface of the solar cell or decreasing a surface current.

To resolve another technical problem, the present invention further provides a selective passivation contact crystalline silicon PERC cell with high conversion efficiency.

To resolve the foregoing technical problems and achieve corresponding technical effects, the present invention provides a method for preparing a crystalline silicon solar cell, including the following steps:
(1) forming a textured surface on a front face of a silicon wafer;
(2) depositing a tunneling layer and a doped polysilicon layer on the front face of the silicon wafer;
(3) depositing a first anti-reflection film layer on the front face of the silicon wafer; and
(4) removing the tunneling layer, the doped polysilicon layer, and the first anti-reflection film layer in a non-electrode region on the front face of the silicon wafer. In an embodiment, step (4) can be performed using a laser.

The method for preparing a crystalline silicon solar cell may further include the following steps:
(5) forming a textured surface on the front face of the silicon wafer again;
(6) performing phosphorus diffusion on a surface of the silicon wafer;
(7) removing a PN junction on a back face and a periphery of the silicon wafer and phosphosilicate glass on the front face;
(8) depositing a passivation film on the back face of the silicon wafer;
(9) depositing a second anti-reflection film layer on the front face of the silicon wafer;
(10) performing laser perforation on the back face of the silicon wafer;
(11) etching back electrode paste and aluminum paste on the back face of the silicon wafer; and etching positive electrode paste on the front face of the silicon wafer and drying;
(12) sintering the silicon wafer obtained in step (11) at a high temperature, to form a back electrode, an aluminum back electric field, and a positive electrode and obtain a selective passivation contact crystalline silicon solar cell product.

In some embodiments, the tunneling layer is an SiO₂ layer with a thickness of 0.5-8 nm; a thickness of the doped polysilicon layer is 5-250 nm, particularly 20-100 nm.

In some embodiments, a thickness of the tunneling layer is 0.5-3 nm; a thickness of the doped polysilicon layer is 50-150 nm, particularly 50-80 nm.

In some embodiments, after step (2) is completed, sheet resistance of the silicon wafer is 40-160 Ω/sq, particularly 40-80 Ω/sq.

In some embodiments, in step (3), the first anti-reflection film layer is deposited using a plasma chemical vapor deposition method; the first anti-reflection film layer is a silicon nitride film layer with a thickness of 10-100 nm, particularly 10-40 nm.

In some embodiments, the positive electrode is in contact with the tunneling layer through the doped polysilicon layer, the first anti-reflection film layer, and the second anti-reflection film layer.

In some embodiments, the silicon wafer is P-type monocrystalline silicon; the doped polysilicon layer is a phosphorus-doped N⁺ type polysilicon layer.

In some embodiments, a mixed solution of NaOH, Na₂SiO₃, and isopropanol is used to etch the surface of the silicon wafer to prepare a textured surface.

Correspondingly, the present invention further discloses a crystalline silicon solar cell, including: a silicon wafer; an anti-reflection film layer and a positive electrode arranged on a front face of the silicon wafer; and a passivation film, a back electrode, and a back electric field arranged on a back face of the silicon wafer.

A tunneling layer, a doped polysilicon layer, and an anti-reflection film layer are arranged between the positive electrode and the silicon wafer; the crystalline silicon solar cell can be prepared using the foregoing preparation method. The present disclosure further provides a crystalline silicon solar cell, including: a silicon wafer; and an anti-reflection film layer and a positive electrode arranged on a front face of the silicon wafer. A tunneling layer, a doped polysilicon layer, and an anti-reflection film layer are arranged between the positive electrode and the silicon wafer. In a region having no positive electrode on the front face of the silicon wafer, the anti-reflection film layer is in direct contact with the silicon wafer.

In some embodiments, the crystalline silicon solar cell further includes: a passivation film, a back electrode, and a back electric field arranged on a back face of the silicon wafer.

In some embodiments, the tunneling layer is an SiO₂ layer with a thickness of 0.5-8 nm; a thickness of the doped polysilicon layer is 5-250 nm. Particularly, a thickness of the tunneling layer is 0.5-3 nm; a thickness of the doped polysilicon layer is 50-150 nm.

In some embodiments, the anti-reflection film layer is deposited using a plasma chemical vapor deposition method, and the anti-reflection film layer is a silicon nitride film layer.

In some embodiments, the silicon wafer is P-type monocrystalline silicon; the doped polysilicon layer is a phosphorus-doped N⁺ type polysilicon layer.

In some embodiments, the passivation film includes an aluminum oxide film and a silicon nitride film, and the aluminum oxide film is arranged between the silicon wafer and the silicon nitride film.

In some embodiments, the passivation film includes an opening, and the back electric field is in contact with the silicon wafer through the opening.

According to the present invention, a selective passivation contact crystalline silicon solar cell is prepared through the following processes: front-face texturing; depositing a tunneling layer, a doped polysilicon layer, and an anti-reflection film layer on the front face; front-face film removal; front-face texturing; diffusion; etching; depositing a passivation film on the back face; depositing an anti-reflection film on the front face; back-face perforation; electrode etching; and sintering. Implementation of the present invention brings the following beneficial effects:
1. The present invention uses the preparation methods of texturing, deposition, and laser removal, thus effectively ensuring that the passivation tunneling layer is selectively deposited in the positive electrode region, and effectively exert a passivation effect. In addition, a non-electrode region is not blocked, thus reducing a degree to which a conventional doped silicon layer absorbs solar energy, and improving the efficiency of a solar cell.
2. The present invention uses the passivation tunneling technology to deposit a silicon dioxide layer between the silicon wafer and the positive electrode. The passivation tunneling technology can bend the energy band and block movement of an electron hole toward the front face. However, a majority of carrier electrons can tunnel through the silicon dioxide layer. This achieves separation of electrons and electron holes, thereby reducing the loss of a fill factor and improving the efficiency of a solar cell.

### Detailed Description of Embodiments

To make the objectives, technical solutions, and advantages of the present invention clearer and more comprehensible, the following further describes the present invention in detail with reference to embodiments. It should be understood that the specific embodiments described herein are merely used to explain the present invention but are not intended to limit the present invention.

The present invention provides a method for preparing a selective passivation contact crystalline silicon solar cell, including the following steps:
(1) Form a textured surface on a front face of a silicon wafer.
   The silicon wafer is cleaned to remove an organic matter and a damaged layer on the surface; then a texturing operation is performed; specifically, the wet etching technology is used to form a textured surface on the front face of the silicon wafer; in an example, after texturing, a weight of the silicon wafer is reduced by 0.55-0.85 g, and reflectivity of the silicon wafer is 10.5%-11.5%. Controlling the reflectivity of the silicon wafer after texturing is conducive to controlling reflectivity of a solar cell with respect to sunlight at a later stage, thus effectively increasing an absorption rate of the solar cell with respect to sunlight, and improving the conversion efficiency of the solar cell.
(2) Deposit a tunneling layer and a doped polysilicon layer on the front face of the silicon wafer.
   The tunneling layer is a silicon dioxide layer. The tunneling layer can effectively separate electrons and electron holes, reduce the loss of a surface fill factor, and improve the efficiency of a solar cell. In an example, a thickness of the tunneling layer is 0.5-8 nm; a thickness of the doped polysilicon layer is 5-250 nm, particularly 20-100 nm; the tunneling layer and the doped polysilicon layer within these thickness ranges can effectively ensure the transmission of electrons and improve the efficiency of a solar cell. In another example, a thickness of the tunneling layer is 0.5-5 nm, particularly 0.5-3 nm; a thickness of the doped polysilicon layer is 50-200 nm, particularly 50-150 nm, further particularly 50-100 nm, or even particularly 50-80 nm; the polysilicon layer and the tunneling layer within these thickness ranges can better exert a passivation effect, improve the efficiency of a solar cell, and at the same time, can reduce the difficulty of deposition.
   In an embodiment, the tunneling layer and the doped polysilicon layer are deposited on the surface of the silicon wafer by using the low pressure chemical vapor deposition (LPCVD) method; the low pressure chemical vapor deposition method can be used to deposit a uniformly thick and tightly bonded silicon dioxide layer on the silicon wafer substrate through chemical reaction at a relatively low temperature; a reaction temperature is relatively low, which is less than 500°C; a deposition speed is high and energy is saved; the low pressure chemical vapor deposition method can be used to prepare a dense tunneling layer and a doped polysilicon layer to ensure the high efficiency of a solar cell at a later stage.
   In an example, after the tunneling layer and the doped polysilicon layer are deposited, surface sheet resistance of the silicon wafer is 40-160 Ω/sq, particularly 40-120 Ω/sq, or further particularly 40-80 Ω/sq; depositing a tunneling layer and a doped polysilicon layer on the surface can effectively reduce the surface sheet resistance of the silicon wafer, making the ohmic contact between the positive electrode and the silicon wafer substrate more sufficient, and improving the conversion efficiency of a solar cell.
(3) Deposit an anti-reflection film layer on the front face of the silicon wafer.
   The anti-reflection film layer is made of silicon nitride material, and silicon nitride (SiN*ₓ*) can effectively reduce the reflection of sunlight on the surface of the silicon wafer and improve the absorption of sunlight, thereby improving the efficiency of a solar cell. In addition, the silicon nitride film can achieve a good passivation effect. For example, the present invention uses a plasma chemical vapor deposition method to deposit an anti-reflection film layer on the front face of the silicon wafer. In an example, a thickness of the anti-reflection film is 10-100 nm, particularly 20-80 nm, or further particularly 20-40 nm; recombination of the silicon dioxide tunneling layer, the doped polysilicon layer, and the silicon nitride layer allows the front face of the silicon wafer to achieve a good passivation effect, while ensuring the effective transmission of carriers and improving the efficiency of a solar cell.
(4) Remove the tunneling layer, the doped polysilicon layer, and the anti-reflection film layer in a non-electrode region on the front face of the silicon wafer by using a laser.
   For example, a DR laser cutting machine is used to cut the tunneling layer, the doped polysilicon layer, and the anti-reflection film layer in the non-electrode region on the front face of the silicon wafer, so as to remove the tunneling layer, the doped polysilicon layer, and the anti-reflection film layer in the non-electrode region. After this step, a selective passivation contact film is formed in the positive electrode region of the solar cell. The selective passivation contact film removes the doped polysilicon layer in the non-electrode region, reduces the absorption of sunlight by the polysilicon layer in the non-electrode region, and improves the efficiency of a solar cell.
   It should be noted that the conventional tunneling oxide layer passivation contact technology is to cover a complete tunneling layer and a complete doped silicon film layer on the surface of the cell. This arrangement allows the doped silicon film layer to absorb a lot of sunlight and reduces the efficiency of a solar cell. The present invention has developed a process of removing a passivation film in the non-electrode region, retaining the passivation film only in the electrode region to form a selective passivation contact film. This achieves the purpose of effectively passivating the positive electrode region without affecting light absorption, thus effectively improving the efficiency of a solar cell.
   The method for preparing a crystalline silicon solar cell may further include the following steps:
(5) Form a textured surface on the front face of the silicon wafer again.
   Specifically, the wet etching technology is used to form a textured surface on the front face of the silicon wafer; forming a textured surface again can effectively remove a damaged layer generated in step (4), while preparing the textured surface to reduce the reflectivity of the crystalline silicon surface. In an example, a weight of the silicon wafer is reduced by 0.15-0.35 g during the texturing. Controlling the reduction of the weight of the silicon wafer during texturing can effectively control the reflectivity of the silicon wafer after texturing. Controlling the reflectivity of the silicon wafer after texturing is conducive to controlling reflectivity of a solar cell with respect to sunlight at a later stage, thus effectively increasing an absorption rate of the solar cell with respect to sunlight, and improving the conversion efficiency of the solar cell.
   In an embodiment, a mixed solution of NaOH, Na₂SiO₃, and isopropanol is used to etch the surface of the silicon wafer to prepare a textured surface. The wet etching texturing technology can be divided into the use of an acidic solution to etch silicon wafers and the use of an alkaline solution to etch silicon wafers. The use of an alkaline solution for texturing can prevent the reaction with the selective passivation film that has been formed, and ensure the integrity of the selective passivation film in the positive electrode region.
(6) Perform phosphorus diffusion on a surface of the silicon wafer.
   Phosphorus diffusion is performed on the surface of the silicon wafer by using the low surface concentration diffusion process technology. In an embodiment, a conventional silicon wafer that has undergone step (5) is used as a reference wafer to monitor the change of the silicon wafer in the phosphorus diffusion process. After phosphorus doping, sheet resistance of the reference wafer is 100-160 Ω/sq, particularly 120-160 Ω/sq. Increasing surface sheet resistance of the silicon wafer can reduce the surface doping concentration. This not only can improve the shortwave effect of the cell and increase the short-circuit current, but also can reduce the dark saturation current caused by surface recombination and increase the open-circuit voltage, thereby optimizing the cell performance.
(7) Remove a PN junction on a back face and a periphery of the silicon wafer and phosphosilicate glass on the front face.
   An HF solution is used to remove the PN junction generated on the back face and the periphery of the silicon wafer, and at the same time, remove the phosphosilicate glass generated on the front face of the silicon wafer.
(8) Deposit a passivation film on the back face of the silicon wafer.
   The passivation film is a laminated passivation film. Specifically, the passivation film is a two-layer film. The layer near the silicon wafer substrate is an aluminum oxide film, and the second layer is a silicon nitride film. The PECAD method can be used to deposit the passivation film. Backside passivation can effectively reduce the backside recombination of silicon wafers, increase the open-circuit voltage, and improve the conversion efficiency of a solar cell.
(9) Deposit an anti-reflection film on the front face of the silicon wafer for the second time.
   The anti-reflection film is a silicon nitride film. The PECAD method can be used to deposit the anti-reflection film. In an example, the deposition thickness is 50-80 nm, particularly 60-80 nm. The anti-reflection film on the front face can effectively improve the absorption rate of solar energy and improve the conversion efficiency of a solar cell.
(10) Perform laser perforation on the back face of the silicon wafer.
   For example, a DR laser is used to perforate the passivation film on the back face, so that ohmic contact is formed between the aluminum on the back face of the silicon wafer and the silicon substrate.
(11) Etch back electrode paste and aluminum paste on the back face of the silicon wafer; and etch positive electrode paste on the front face of the silicon wafer and dry.
(12) Sinter the silicon wafer obtained in step (11) at a high temperature, to form a back electrode, an aluminum back electric field, and a positive electrode and obtain a selective passivation contact crystalline silicon solar cell product.

Correspondingly, the present invention further discloses a selective passivation contact crystalline silicon solar cell, including: a silicon wafer; an anti-reflection film layer and a positive electrode arranged on a front face of the silicon wafer; and a passivation film, a back electrode, and a back electric field arranged on a back face of the silicon wafer.

A tunneling layer, a doped polysilicon layer, and an anti-reflection film layer are arranged between the positive electrode and the silicon wafer. In an embodiment, the positive electrode is in contact with the passivation tunneling layer through the anti-reflection film layer and the doped polysilicon layer.

The selective passivation contact crystalline silicon solar cell can be prepared using the foregoing preparation method. The following provides a further description with reference to specific embodiments.

### Embodiment 1

In this embodiment, a method for preparing a selective passivation contact crystalline silicon solar cell is as follows:
(1) Form a textured surface on a front face of a silicon wafer: 800 pieces of P-type silicon wafers are selected as substrate materials; the wet etching technology is used to form a textured surface on a surface of the silicon wafer; the weight loss is controlled to be 0.55 g and the reflectivity is 10.5%.
(2) Deposit a tunneling layer and a doped polysilicon layer on the front face of the silicon wafer: the LPCVD method is used for deposition; the tunneling layer is silicon dioxide; the doped polysilicon layer is phosphorus-doped N⁺ polysilicon; a thickness of the tunneling layer is 1 nm, and a thickness of the doped polysilicon layer is 20 nm.
(3) Deposit an anti-reflection film layer on the front face of the silicon wafer: the PECVD method is used for deposition; the anti-reflection film layer is silicon nitride; a thickness of the anti-reflection film layer is 10 nm.
(4) Remove the tunneling layer, the doped polysilicon layer, and the anti-reflection film layer in a non-electrode region on the front face of the silicon wafer by using a laser: a DR laser cutting machine is used to remove a film in a non-electrode region on the front face.
(5) Form a textured surface on the front face of the silicon wafer again: a mixed solution of NaOH, Na₂SiO₃, and isopropanol is used for etching to form a new textured surface in the non-electrode region; a weight of the silicon wafer is reduced by 0.15 g during texturing.
(6) Perform phosphorus diffusion on a surface of the silicon wafer: the low concentration diffusion technology is used to form a PN junction; a silicon wafer that has only been textured is used as a reference wafer, and sheet resistance of the reference wafer after diffusion is I00 Ω/sq.
(7) Remove a PN junction on a back face and a periphery of the silicon wafer and phosphosilicate glass on the front face: an HF solution is used to remove the PN junction on the back face and the periphery of the silicon wafer and the phosphosilicate glass on the front face.
(8) Deposit a passivation film on the back face of the silicon wafer: the PECVD method is used for deposition; the passivation film is made of aluminum oxide and silicon nitride.
(9) Deposit an anti-reflection film on the front face of the silicon wafer for the second time: the PECVD method is used for deposition; the anti-reflection film is silicon nitride; a thickness of the anti-reflection film is 50 nm.
(10) Perform laser perforation on the back face of the silicon wafer: a DR laser cutting machine is used to perform perforation on the back face of the silicon wafer.
(11) Etch back electrode paste and aluminum paste on the back face of the silicon wafer; and etch positive electrode paste on the front face of the silicon wafer and dry.
(12) Sinter the silicon wafer obtained in step (11) at a high temperature, to form a back electrode, an aluminum back electric field, and a positive electrode and obtain a selective passivation contact crystalline silicon solar cell product.

### Embodiment 2

In this embodiment, a method for preparing a selective passivation contact crystalline silicon solar cell is as follows:
(1) Form a textured surface on a front face of a silicon wafer: 800 pieces of P-type silicon wafers are selected as substrate materials; the wet etching technology is used to form a textured surface on a surface of the silicon wafer; the weight loss is controlled to be 0.85 g and the reflectivity is 11.5%.
(2) Deposit a tunneling layer and a doped polysilicon layer on the front face of the silicon wafer: the LPCVD method is used for deposition; the tunneling layer is silicon dioxide; the doped polysilicon layer is phosphorus-doped N⁺ polysilicon; a thickness of the tunneling layer is 8 nm, and a thickness of the doped polysilicon layer is 100 nm.
(3) Deposit an anti-reflection film layer on the front face of the silicon wafer: the PECVD method is used for deposition; the anti-reflection film layer is silicon nitride; a thickness of the anti-reflection film layer is 40 nm.
(4) Remove the tunneling layer, the doped polysilicon layer, and the anti-reflection film layer in a non-electrode region on the front face of the silicon wafer by using a laser: a DR laser cutting machine is used to remove a film in a non-electrode region on the front face.
(5) Form a textured surface on the front face of the silicon wafer again: a mixed solution of NaOH, Na₂SiO₃, and isopropanol is used for etching to form a new textured surface in the non-electrode region; a weight of the silicon wafer is reduced by 0.35 g during texturing.
(6) Perform phosphorus diffusion on a surface of the silicon wafer: the low concentration diffusion technology is used to form a PN junction; a silicon wafer that has only been textured is used as a reference wafer, and sheet resistance of the reference wafer after diffusion is 160 Ω/sq.
(7) Remove a PN junction on a back face and a periphery of the silicon wafer and phosphosilicate glass on the front face: an HF solution is used to remove the PN junction on the back face and the periphery of the silicon wafer and the phosphosilicate glass on the front face.
(8) Deposit a passivation film on the back face of the silicon wafer: the PECVD method is used for deposition; the passivation film is made of aluminum oxide and silicon nitride.
(9) Deposit an anti-reflection film on the front face of the silicon wafer for the second time: the PECVD method is used for deposition; the anti-reflection film is silicon nitride; a thickness of the anti-reflection film is 80 nm.
(10) Perform laser perforation on the back face of the silicon wafer: a DR laser cutting machine is used to perform perforation on the back face of the silicon wafer.
(11) Etch back electrode paste and aluminum paste on the back face of the silicon wafer; and etch positive electrode paste on the front face of the silicon wafer and dry.
(12) Sinter the silicon wafer obtained in step (11) at a high temperature, to form a back electrode, an aluminum back electric field, and a positive electrode and obtain a selective passivation contact crystalline silicon solar cell product.

### Embodiment 3

In this embodiment, a method for preparing a selective passivation contact crystalline silicon solar cell is as follows:
(1) Form a textured surface on a front face of a silicon wafer: 800 pieces of P-type silicon wafers are selected as substrate materials; the wet etching technology is used to form a textured surface on a surface of the silicon wafer; the weight loss is controlled to be 0.65 g and the reflectivity is 11%.
(2) Deposit a tunneling layer and a doped polysilicon layer on the front face of the silicon wafer: the LPCVD method is used for deposition; the tunneling layer is silicon dioxide; the doped polysilicon layer is phosphorus-doped N⁺ polysilicon; a thickness of the tunneling layer is 2 nm, and a thickness of the doped polysilicon layer is 55 nm.
(3) Deposit an anti-reflection film layer on the front face of the silicon wafer: the PECVD method is used for deposition; the anti-reflection film layer is silicon nitride; a thickness of the anti-reflection film layer is 35 nm.
(4) Remove the tunneling layer, the doped polysilicon layer, and the anti-reflection film layer in a non-electrode region on the front face of the silicon wafer by using a laser: a DR laser cutting machine is used to remove a film in a non-electrode region on the front face.
(5) Form a textured surface on the front face of the silicon wafer again: a mixed solution of NaOH, Na₂SiO₃, and isopropanol is used for etching to form a new textured surface in the non-electrode region; a weight of the silicon wafer is reduced by 0.22 g during texturing.
(6) Perform phosphorus diffusion on a surface of the silicon wafer: the low concentration diffusion technology is used to form a PN junction; a silicon wafer that has only been textured is used as a reference wafer, and sheet resistance of the reference wafer after diffusion is 135 Ω/sq.
(7) Remove a PN junction on a back face and a periphery of the silicon wafer and phosphosilicate glass on the front face: an HF solution is used to remove the PN junction on the back face and the periphery of the silicon wafer and the phosphosilicate glass on the front face.
(8) Deposit a passivation film on the back face of the silicon wafer: the PECVD method is used for deposition; the passivation film is made of aluminum oxide and silicon nitride.
(9) Deposit an anti-reflection film on the front face of the silicon wafer for the second time: the PECVD method is used for deposition; the anti-reflection film is silicon nitride; a thickness of the anti-reflection film is 65 nm.
(10) Perform laser perforation on the back face of the silicon wafer: a DR laser cutting machine is used to perform perforation on the back face of the silicon wafer.
(11) Etch back electrode paste and aluminum paste on the back face of the silicon wafer; and etch positive electrode paste on the front face of the silicon wafer and dry.
(12) Sinter the silicon wafer obtained in step (11) at a high temperature, to form a back electrode, an aluminum back electric field, and a positive electrode and obtain a selective passivation contact crystalline silicon solar cell product.

### Embodiment 4

In this embodiment, a method for preparing a selective passivation contact crystalline silicon solar cell is as follows:
(1) Form a textured surface on a front face of a silicon wafer: 800 pieces of P-type silicon wafers are selected as substrate materials; the wet etching technology is used to form a textured surface on a surface of the silicon wafer; the weight loss is controlled to be 0.7 g and the reflectivity is 10.7%.
(2) Deposit a tunneling layer and a doped polysilicon layer on the front face of the silicon wafer: the LPCVD method is used for deposition; the tunneling layer is silicon dioxide; the doped polysilicon layer is phosphorus-doped N⁺ polysilicon; a thickness of the tunneling layer is 2.5 nm, and a thickness of the doped polysilicon layer is 65 nm.
(3) Deposit an anti-reflection film layer on the front face of the silicon wafer: the PECVD method is used for deposition; the anti-reflection film layer is silicon nitride; a thickness of the anti-reflection film layer is 30 nm.
(4) Remove the tunneling layer, the doped polysilicon layer, and the anti-reflection film layer in a non-electrode region on the front face of the silicon wafer by using a laser: a DR laser cutting machine is used to remove a film in a non-electrode region on the front face.
(5) Form a textured surface on the front face of the silicon wafer again: a mixed solution of NaOH, Na₂SiO₃, and isopropanol is used for etching to form a new textured surface in the non-electrode region; a weight of the silicon wafer is reduced by 0.25 g during texturing.
(6) Perform phosphorus diffusion on a surface of the silicon wafer: the low concentration diffusion technology is used to form a PN junction; a silicon wafer that has only been textured is used as a reference wafer, and sheet resistance of the reference wafer after diffusion is 140 Ω/sq.
(7) Remove a PN junction on a back face and a periphery of the silicon wafer and phosphosilicate glass on the front face: an HF solution is used to remove the PN junction on the back face and the periphery of the silicon wafer and the phosphosilicate glass on the front face.
(8) Deposit a passivation film on the back face of the silicon wafer: the PECVD method is used for deposition; the passivation film is made of aluminum oxide and silicon nitride.
(9) Deposit an anti-reflection film on the front face of the silicon wafer for the second time: the PECVD method is used for deposition; the anti-reflection film is silicon nitride; a thickness of the anti-reflection film is 70 nm.
(10) Perform laser perforation on the back face of the silicon wafer: a DR laser cutting machine is used to perform perforation on the back face of the silicon wafer.
(11) Etch back electrode paste and aluminum paste on the back face of the silicon wafer; and etch positive electrode paste on the front face of the silicon wafer and dry.
(12) Sinter the silicon wafer obtained in step (11) at a high temperature, to form a back electrode, an aluminum back electric field, and a positive electrode and obtain a selective passivation contact crystalline silicon solar cell product.

### Reference Embodiment 1

This embodiment is divided into 11 steps. Steps (1) to (3) are the same as those in Embodiment 4 of the present invention. Steps (4) to (11) are the same as steps (5) to (12) in Embodiment 4 of the present invention.

The performance of the selective passivation contact crystalline silicon solar cell in Embodiments 1-4 and the reference embodiment is measured, and the results are shown in Table 1.

**Table 1**

| | J_{sc} (mA/cm²) | Efficiency (%) |
|---|---|---|
| Embodiment 1 | 31 | 20.88 |
| Embodiment 2 | 39 | 21.00 |
| Embodiment 3 | 39 | 21.94 |
| Embodiment 4 | 42 | 21.98 |
| Reference embodiment | 22 | 20.05 |

It can be seen from the table that the efficiency of the selective passivation contact crystalline silicon solar cell in the present invention is increased by approximately 0.8%-1.9%, and the efficiency is significantly improved.

The present disclosure further relates to a crystalline silicon solar cell prepared using the foregoing method.

The present disclosure further provides a crystalline silicon solar cell, including: a silicon wafer; and an anti-reflection film layer and a positive electrode arranged on a front face of the silicon wafer. A tunneling layer, a doped polysilicon layer, and an anti-reflection film layer are arranged between the positive electrode and the silicon wafer. In a region having no positive electrode on the front face of the silicon wafer, the anti-reflection film layer is in direct contact with the silicon wafer.

In some embodiments, the crystalline silicon solar cell further includes: a passivation film, a back electrode, and a back electric field arranged on a back face of the silicon wafer.

In some embodiments, the tunneling layer is an SiO₂ layer with a thickness of 0.5-8 nm; a thickness of the doped polysilicon layer is 5-250 nm. Particularly, a thickness of the tunneling layer is 0.5-3 nm; a thickness of the doped polysilicon layer is 50-150 nm.

In some embodiments, the anti-reflection film layer is deposited using a plasma chemical vapor deposition method, and the anti-reflection film layer is a silicon nitride film layer.

In some embodiments, the silicon wafer is P-type monocrystalline silicon; the doped polysilicon layer is a phosphorus-doped N⁺ type polysilicon layer.

In some embodiments, the passivation film includes an aluminum oxide film and a silicon nitride film, and the aluminum oxide film is arranged between the silicon wafer and the silicon nitride film.

In some embodiments, the passivation film includes an opening, and the back electric field is in contact with the silicon wafer through the opening.

The foregoing descriptions are merely example embodiments of the present invention, but are not intended to limit the present invention. Any modification, equivalent replacement, improvement, and the like made without departing from the spirit and principle of the present invention should fall within the protection scope of the present invention.

## Claims

1. A method for preparing a crystalline silicon solar cell, comprising the following steps:
(1) forming a textured surface on a front face of a silicon wafer;
(2) depositing a tunneling layer and a doped polysilicon layer on the front face of the silicon wafer;
(3) depositing a first anti-reflection film layer on the front face of the silicon wafer; and
(4) removing the tunneling layer, the doped polysilicon layer, and the first anti-reflection film layer in a non-electrode region on the front face of the silicon wafer.

2. The method for preparing a crystalline silicon solar cell according to claim 1, further comprising the following steps:
(5) forming a textured surface on the front face of the silicon wafer again;
(6) performing phosphorus diffusion on a surface of the silicon wafer;
(7) removing a PN junction on a back face and a periphery of the silicon wafer and phosphosilicate glass on the front face;
(8) depositing a passivation film on the back face of the silicon wafer;
(9) depositing a second anti-reflection film layer on the front face of the silicon wafer;
(10) performing laser perforation on the back face of the silicon wafer;
(11) etching back electrode paste and aluminum paste on the back face of the silicon wafer; and etching positive electrode paste on the front face of the silicon wafer and drying; and
(12) sintering the silicon wafer obtained in step (11) at a high temperature, to form a back electrode, an aluminum back electric field, and a positive electrode.

3. The method for preparing a crystalline silicon solar cell according to claim 1, wherein the tunneling layer is an SiO₂ layer with a thickness of 0.5-8 nm; and a thickness of the doped polysilicon layer is 5-250 nm.

4. The method for preparing a crystalline silicon solar cell according to claim 3, wherein the thickness of the tunneling layer is 0.5-3 nm; and the thickness of the doped polysilicon layer is 50-150 nm.

5. The method for preparing a crystalline silicon solar cell according to claim 3, wherein after step (2) is completed, sheet resistance of the silicon wafer is 40-160 Ω/sq.

6. The method for preparing a crystalline silicon solar cell according to claim 1, wherein in step (3), the first anti-reflection film layer is deposited using a plasma chemical vapor deposition method; the first anti-reflection film layer is a silicon nitride film layer with a thickness of 10-100 nm.

7. The method for preparing a crystalline silicon solar cell according to claim 2, wherein the positive electrode is in contact with the tunneling layer through the doped polysilicon layer, the first anti-reflection film layer, and the second anti-reflection film layer.

8. The method for preparing a crystalline silicon solar cell according to claim 1, wherein the silicon wafer is P-type monocrystalline silicon; and the doped polysilicon layer is a phosphorus-doped N⁺ type polysilicon layer.

9. The method for preparing a crystalline silicon solar cell according to claim 2, wherein in step (5), a mixed solution of NaOH, Na₂SiO₃, and isopropanol is used to etch the surface of the silicon wafer to prepare a textured surface.

10. The method for preparing a crystalline silicon solar cell according to claim 1, wherein step (4) is performed using a laser.

11. A crystalline silicon solar cell, wherein the crystalline silicon solar cell is prepared using the method for preparing a crystalline silicon solar cell according to any one of claims 1 to 10.

12. A crystalline silicon solar cell, comprising: a silicon wafer; and an anti-reflection film layer and a positive electrode arranged on a front face of the silicon wafer, wherein
a tunneling layer, a doped polysilicon layer, and the anti-reflection film layer are arranged between the positive electrode and the silicon wafer; and
in a region having no positive electrode on the front face of the silicon wafer, the anti-reflection film layer is in direct contact with the silicon wafer.

13. The crystalline silicon solar cell according to claim 12, further comprising: a passivation film, a back electrode, and a back electric field arranged on a back face of the silicon wafer.

14. The crystalline silicon solar cell according to claim 12, wherein the tunneling layer is an SiO₂ layer with a thickness of 0.5-8 nm; and a thickness of the doped polysilicon layer is 5-250 nm.

15. The crystalline silicon solar cell according to claim 14, wherein the thickness of the tunneling layer is 0.5-3 nm; and the thickness of the doped polysilicon layer is 50-150 nm.

16. The crystalline silicon solar cell according to claim 12, wherein the anti-reflection film layer is deposited using a plasma chemical vapor deposition method, and the anti-reflection film layer is a silicon nitride film layer.

17. The crystalline silicon solar cell according to claim 12, wherein the silicon wafer is P-type monocrystalline silicon; and the doped polysilicon layer is a phosphorus-doped N⁺ type polysilicon layer.

18. The crystalline silicon solar cell according to claim 13, wherein the passivation film comprises an aluminum oxide film and a silicon nitride film, and the aluminum oxide film is arranged between the silicon wafer and the silicon nitride film.

19. The crystalline silicon solar cell according to claim 13, wherein the passivation film comprises an opening, and the back electric field is in contact with the silicon wafer through the opening.
